# EUROPÄISCHE PATENTSCHRIFT

(11) **EP 2 616 827 B1**
(45) Veröffentlichungstag und Bekanntmachung des Hinweises auf die Patenterteilung: **12.12.2018**
(21) Anmeldenummer: 11767623.9
(22) Anmeldetag: 14.09.2011
(51) Int. Cl.: G01R 31/28, G01R 31/30, G01R 31/317, G05B 23/02

(54) **VORRICHTUNG ZUR BETRIEBSPARAMETER-ÜBERWACHUNG INTEGRIERTER SCHALTKREISE UND INTEGRIERTER SCHALTKREIS MIT BETRIEBSPARAMETER-ÜBERWACHUNG**
APPARATUS FOR MONITORING OPERATING PARAMETERS OF INTEGRATED CIRCUITS AND INTEGRATED CIRCUIT WITH OPERATING PARAMETER MONITORING
DISPOSITIF DE SURVEILLANCE DE PARAMÈTRES DE FONCTIONNEMENT DE CIRCUITS INTÉGRÉS ET CIRCUIT INTÉGRÉ DOTÉ D'UNE SURVEILLANCE DE PARAMÈTRES

(30) Priorität: 14.09.2010 DE 102010045278
(43) Veröffentlichungstag der Anmeldung: 24.07.2013
(73) Patentinhaber: Phoenix Contact GmbH & Co. KG, 32825 Blomberg (DE)
(72) Erfinder: WEISS, Dominik, 31855 Aerzen (DE)
(74) Vertreter: Blumbach · Zinngrebe Patent- und Rechtsanwälte
(86) Internationale Anmeldenummer: PCT/EP2011/004602
(87) Internationale Veröffentlichungsnummer: WO 2012/034682

(56) Entgegenhaltungen:
- US-A1- 2008 007 272

## Beschreibung

Die Erfindung betrifft allgemein eine Vorrichtung zur Betriebsparameter-Überwachung von Integrierten Schaltkreisen.

Als Betriebsparameter kommen insbesondere die Betriebsspannung bzw. die Spannungsversorgung und/oder die Betriebstemperatur von Integrierten Schaltkreisen in Betracht.

Damit Integrierte Schaltkreise (IC engl.: Integrated Circuits) sicher betrieben werden können, müssen Grenzwerte für die Betriebsparameter wie beispielsweise die Spannungsversorgung und/oder die Betriebstemperatur eingehalten werden. Wird z.B. die zulässige oder vorgegebene Grenze der Spannungsversorgung unter- oder überschritten, ist ein fehlerfreier Betrieb des IC nicht mehr gewährleistet. Soll auch bei zu kleiner Spannungsversorgung ein definierter Zustand erreicht werden, wird üblicherweise ein Spannungsmonitor IC eingesetzt, welches die Spannung überwacht und bei unterschreiten einer definierten Schwelle ein Resetsignal generiert.

Die zunehmend kleiner werdenden Spannungsversorgungen mit immer kleiner werdenden zulässigen Toleranzen lassen sich zunehmend schwieriger und kostspieliger überwachen. Teilweise werden Spannungsmonitore eingesetzt, welche erst außerhalb der zulässigen Spannungsversorgung ein Resetsignal generieren und damit kleine Bereiche der Spannungsversorgung in einem undefinierten Zustand lassen.

Die üblicherweise eingesetzten Spannungsmonitore enthalten Analoge Schaltungen zur Überwachung der Versorgungsspannung. Es gibt aber auch in digitalen ICs integrierte Spannungsmonitore. Jedoch ist es schwieriger analoge Schaltungen in ein Digitales IC mit zu integrieren. Entsprechend sind die Integrierten Spannungsmonitore sehr ungenau und lassen einen sehr weiten Spannungsbereich undefiniert.

Als Beispiel für die Betriebsspannung eines Integrierten Schaltkreis sei die Kernspannung für den FPGA **Cyclon III** der Firma Altera (www.altera.com) angegeben. Der zulässige Bereich ist laut Datenblatt (Herstellerangaben):

| | |
|---|---|
| Maximal: | 1,25V |
| Typisch: | 1,2V |
| Minimal: | 1,15V |

Eine typische Auslöseschelle des integrierten Spannungsmonitors ist U = 0,77V. Damit ergibt sich ein undefinierter Bereich von 0,77V bis 1,15V. In diesem Bereich ist das Verhalten des IC undefiniert. Es kann nicht sicher davon ausgegangen werden, dass die Schaltung bzw. der FPGA seine Funktion erfüllt.

Zusätzlich erhöhen alle Spannungsmonitore die Kosten einer Schaltung. Insbesondere bei hohen Stückzahlen könnten so wirtschaftlich beträchtliche Kosten eingespart werden, sofern auf die externen oder internen Spannungsmonitore verzichtet werden könnte.

Nachteilig ist des Weiteren, dass die Spannungsmonitore Platz auf dem Schaltungsboard, der Leiterplatte oder der Chipfläche einnehmen. Während Chipfläche allgemein sehr kostbar ist, stellt sich deren Platzbedarf auch dem allgemeinen Trend zur Miniaturisierung entgegen.

Weiter noch müssen die Spannungsmonitore an die Schaltung angepasst bzw. berechnet werden. Spannungsmonitore deren undefinierter Bereich geringer ist als der in dem obigen Beispiel angegebene, benötigen höhere Anforderungen an die Toleranz, was die Herstellungskosten erhöht.

Der Erfindung liegt somit die Aufgabe zugrunde, eine Betriebsparameter-Überwachung zu schaffen, die keinen undefinierten Bereich bei der Betriebsparameter-Überwachung aufweist und insbesondere gut in digitale Schaltungen zu integrieren und gleichzeitig kostengünstig ist.

Diese Aufgabe wird durch den Gegenstand des unabhängigen Anspruchs gelöst. Vorteilhafte Ausgestaltungen sind in den jeweiligen Unteransprüchen angegeben.

Unter digitalen Schaltkreisen werden dabei im Folgenden alle Schaltkreisen verstanden, die im weitesten Sinne integrierte Bausteine einsetzen. Beispiele für diese Integrierten Schaltkreise, bzw. Bausteine sind zum Beispiel Mikroprozessoren µC (engl. µC; Microprocessor), CPLD's (engl. CPLD; Complex Programming Logic Device), FPGA's (engl. FPGA; Field Programmable Gate Array), ASIC's (engl. ASIC; Application Specific Integrated Circuit), DSP's (engl. DSP; Digital Signal Processor) oder andere Ausgestaltungen programmierbarer Logik wie beispielsweise PLD's (engl. PLD; Programming Logic Device) aber auch analoge Schaltkreisen die lediglich einige wenige, einfacher aufgebaute IC's einsetzten.

Die digitalen Schaltungen bzw. integrierte Schaltkreise oder Bausteine müssen dabei nicht direkt als reale Module vorliegen, sie können auch in einen abstraktren Hardwarebeschreibungssprache wie beispielsweise VHDL (engl. VHDL; Very High Speed Integrated Circuit Description Language) oder Verilog definiert und in programmierbaren Schaltungen umgesetzt sein.

Das Dokument US 2008/007 272 A1 zeigt eine Chip-integrierte Spannungsversorgungsüberwachung, bei welcher das Signal in zwei Signalwege aufgeteilt wird. In einem Signalweg wird das Signal durch ein spannungsempfindliches Verzögerungsglied geleitet, wohingegen in dem anderen Signalweg kein spannungsabhängiges Verzögerungsglied eingegliedert ist. Über einen Phasenvergleich der Ausgangssignale kann eine Über- oder Unterspannung detektiert werden.

Die Erfindung sieht demgemäß eine Vorrichtung zur Betriebsparameter-Überwachung Integrierter Schaltkreise vor in welcher durch einen Vergleich von Schaltzuständen von Eingangssignalen an den zumindest zwei Eingängen eines Vergleichselements an dem zumindest einem Ausgang des Vergleichselements ein Signal generiert wird, dass angibt, dass eine vorgegebene Schwelle des zumindest einen Betriebsparameters unter- oder überschritten worden ist.

Die beiden Eingangssignale werden dazu von zumindest zwei betriebsparameterabhängigen Vorrichtungen generiert und je nach momentanen Wert des zumindest einen Betriebsparameters in ihrem Schaltverhalten zeitlich verzögert. An die beiden betriebsparameterabhängigen Vorrichtungen ist ein Taktsignal angeschlossen, dass jeweils als Eingangsignal für die beiden betriebsparameterabhängigen Vorrichtungen dient. Zwischen diesen beiden Eingangssignalen des Vergleichselements wird eine vorgegebene zeitliche Verzögerung erzeugt, die durch ein Verzögerungselement hervorgerufen wird. Die Verzögerung des Verzögerungselements weist einen Wert auf derart, dass bei Überschreiten der vorgegebenen Schwelle des Betriebsparameters eine der Eingangssignale zu dem, durch das Taktsignal dem Vergleichselement vorgegebenen Zeitpunkten, seinen Schaltzustand aufgrund der vorgegebenen zeitlichen Verzögerung ändert. Aufgrund der Änderung kann das Vergleichselement diese Ungleichheit anzeigen und damit ein Überschreiten der Schwelle des zumindest einen Betriebsparameters signalisieren.

Es ist besonders zweckmäßig, die erfindungsgemäße Vorrichtung direkt in dem zu überwachenden integrierten Baustein zu implementieren. Damit wird erreicht, dass die gleichen Betriebsparameter, welche auf die betriebsparameterabhängigen Vorrichtungen wirken, auch im übrigen Schaltkreis gelten. Demgemäß betrifft die Erfindung auch einen integrierten Schaltkreis mit einer erfindungsgemäßen Vorrichtung, Im Allgemeinen wirken alle die Schaltzeit beeinflussenden Betriebsparameter gemeinsam auf die Vorrichtung ein und bestimmen, ob das Vergleichselement eine Überschreitung der Schwelle der Schaltzeit anzeigt. Die erfindungsgemäße Vorrichtung überwacht damit allgemein, ob die, auch durch herstellungsbedingte Toleranzen beeinflussten Schaltzeiten des integrierten Schaltkreises in einem bestimmten Bereich liegen. Es ist ersichtlich, dass dies einen großen Vorteil der erfindungsgemäßen Vorrichtung zur Betriebsparameter-Überwachung darstellt. Die Vorrichtung kann demgemäß allgemeiner auch als Schaltzeit-Überwachungsvorrichtung bezeichnet werden, wobei das Vergleichselement das Über- oder Unterschreiten einer Schwelle der Schaltzeit anzeigt.

In einer besonders bevorzugten Ausführungsform der erfindungsgemäßen Vorrichtung zur Betriebsparameter-Überwachung Integrierter Schaltkreise, wird das eine Eingangssignal durch Einbringen des Verzögerungselementes, beziehungsweise durch die Auslegung des Verzögerungselementes hinsichtlich der damit erzielten Verzögerung derart verzögert, dass bei einer der betriebsparameterabhängigen Vorrichtungen gerade noch die vorgegebene Anstiegs- oder Haltezeit eingehalten wird, so dass bei Überschreiten der vorgegebenen Schwelle des Betriebsparameters einer der Eingangsschaltzustände seinen Schaltzustand ändert und somit das Vergleichselement diese Ungleichheit anzeigt und damit ein Überschreiten der Schwelle des zumindest einen Betriebsparameters signalisiert wird. Eine Lücke in der Betriebsparameter-Überwachung tritt somit nicht mehr auf.
Mit anderen Worten sollte die zeitliche Verzögerung so gewählt werden, dass bei Erreichen des Grenzwertes des zu überwachenden Betriebsparameters die Setup-Zeit der einen betriebsparameterabhängigen Vorrichtung gerade noch eingehalten wird so dass sich der Schaltzustand am Ausgang noch nicht geändert hat. Wird dieser Grenzwert überschritten, wird die Setup-Zeit nicht mehr eingehalten und am Ausgang der betriebsparameterabhängige Vorrichtung wechselt der Schaltzustand. Der Setup-Zeit der anderen betriebsparameterabhängigen Vorrichtungen soll dabei besser eingehalten werden, so dass sich bei Überschreiten des Grenzwertes dieser Wert noch nicht ändert. Der zeitliche Abstand zueinander kann dabei aber sehr kurz sein, solange am Ausgang bei Überschreiten der vorgegebenen Grenzwertes der Betriebsparameter noch ein ungleicher Schaltzustand zwischen den beiden Signalen vorliegt. So ist ein sicheres Anzeigen der Betriebsparameterüberschreitung gewährleistet.

In einer besonders bevorzugten Ausführungsform der erfindungsgemäßen Betriebsparameter-Überwachung erfolgt die Generierung der beiden Eingangssignale unter Ansprechen auf einen gemeinsamen Takt, der an den beiden betriebsparameterabhängigen Vorrichtungen und an das Vergleichselement angeschlossen ist. Ein zeitsynchroner Prozessablauf ist somit auch in komplizierten Integrierten Schaltkreisen gewährleistet.

In einer besonders bevorzugten Ausführungsform der erfindungsgemäßen Betriebsparameter-Überwachung wird mittels eines weiteren Verzögerungselements der Taktpfad des gemeinsamen Takts der beiden betriebsparameterabhängigen Vorrichtung und des Vergleichselements verlängert, außer des Pfades derjenigen betriebsparameterabhängigen Vorrichtung dessen Eingang nicht mit dem Verzögerungselement versehen ist und wobei das weitere Verzögerungselement derart beschaffen ist, dass ein Über- und ein Unterschreiten registriert wird. So kann mit nur einer Schaltung eine Grenze für das Über- und das Unterschreiten vorgegeben werden.

In einer weiteren besonders bevorzugten Ausführungsform der erfindungsgemäßen Vorrichtung zur Betriebsparameter-Überwachung wird die Betriebsparameterüberwachung in einer Logischen Schaltung, einem Mikroprozessor, einem Digitalen Signalprozessor, einem CPLD, in einem FPGA und/oder in einem ASIC oder vergleichbaren Integrierten Schaltkreis bzw. allgemein in einem PLD implementiert. Damit können die erwähnten Schaltkreise zuverlässiger als bisher betrieben werden, da bei überschreiten der Betriebsparameter ein Signal zur weiteren Verarbeitung zur Verfügung stehet, dass diese Überschreitung anzeigt. Die Implementierung kann dabei intern oder extern erfolgen. Demgemäß kann die erfindungsgemäße Vorrichtung zur Betriebsparameter gemäß einer Weiterbildung der Erfindung in einer der vorgenannten integrierten Schaltungen implementiert sein, oder auch extern an eine dieser integrierten Schaltungen angeschlossen oder Bestandteil einer elektronischen Schaltung mit einer dieser integrierten Schaltungen sein.

Es ist besonders vorteilhaft wenn die betriebparameterabhängigen Verzögerungselemente mittels D-FlipFlops realisiert werden. Diese geben das Signal das an ihrem Eingang liegt synchron zu dem ebenfalls an ihnen anliegenden Takt wieder aus. Je nach Temperatur des IC ist die Ausgabe mit einer Verzögerung behaftet. Mit anderen Worten dient das FlipFlop als Messinstrument bzw. als Indikator wie schnell die Register in dem Integrierten Schaltkreis arbeiten.

Es ist weiterhin vorteilhaft, wenn das Vergleichselement eine Exklusive-Oder-Verknüpfung bzw, eine Exklusive-Oder-Funktionalität aufweist. So wird nur bei Ungleichheit in beiden Signalpfaden ein entsprechendes Signal generiert, dass anzeigt, dass die zulässigen oder vorgegebenen Betriebsparametergrenzen überschritten wurden,

In einer weiteren bevorzugten Ausführungsform der erfindungsgemäßen Vorrichtung zur Betriebsparameter-Überwachung wird die Einrichtung zur Bereitstellung eines abgeleiteten Takts durch einen Frequenzteiler für die Taktsignale gebildet. Dabei wird aus dem gemeinsamen Takt durch Frequenzteiler, beispielsweise mittels eines Flipflops, wie einem D- oder T-FlipFlop, ein abgeleitetes Signal halber Frequenz erzeugt das als abgeleiteter Takt dient. Besonders vorteilhaft ist ein Teilerverhältnis von 1/2. Es sind aber auch andere ganzzahlige Teilerverhältnisse denkbar.

Es ist weiterhin vorteilhaft wenn zur Betriebsparameter-Überwachung zusätzlich ein Spannungsmonitor, beispielsweise implementiert in einem IC, eingesetzt wird. Dieser kann dann aktiv werden, wenn die erfindungsgemäße Betriebsparameter-Überwachung nicht mehr aktiv ist. Mit anderen Worten ist die erfindungsgemäße Betriebsparameter-Überwachung vorzugsweise für den Bereich direkt unter den Grenzen der Betriebsparametern zuständig, während das Spannungsmonitor IC sehr große Abweichungen in den Betriebsparameter erfasst, die von der erfindungsgemäßen Vorrichtung nicht mehr erfasst werden können,

Das Signal, welches das Überschreiten der Betriebsparametergrenzen anzeigt, wird gemäß einer Weiterbildung der Erfindung nicht direkt von dem Vergleichselement, sondern von einem oder mehreren zwischengeschalteten digitalen Filtern erzeugt. Dies ermöglicht eine einfache Anpassung des Signals, beispielsweise hinsichtlich dessen Dauer oder Spannung.

Es ist weiterhin besonders vorteilhaft wenn die erfindungsgemäße Vorrichtung zumindest zweimal mit unterschiedlichen Auslöseschwellen in einer Parallelanordnung aufgebaut ist. Damit kann ein Hystereseverhalten für das Signal das die Betriebsparameterüberschreitung anzeigt erzeugt werden. So kann beispielsweise eine Betriebsparameterüberwachung mit zwei unterschiedlichen Auslöseschwellen aufgebaut werden. Die Schaltung mit der weniger empfindlicheren Auslöseschwelle kann das Signal aktivieren und wenn beide Schaltkreise einen zulässigen Betriebsbereich detektieren kann das Signal wieder zurückgenommen werden. Es können aber auch mehr als zwei Elemente zusammengeschaltet werden. Mit anderen Worten ist in Weiterbildung der Erfindung eine Schaltung mit zumindest zwei erfindungsgemäße Betriebsparameter-Überwachungsvorrichtungen vorgesehen. Die Schaltung kann Bestandteil eines integrierten Schaltkreises sein, oder zumindest einen integrierten Schaltkreis umfassen, dessen Betriebsparameter mit denn beiden erfindungsgemäßen Betriebsparameter-Überwachungsvorrichtungen überwacht werden.
Es ist weiterhin vorteilhaft wenn die erfindungsgemäße Vorrichtung ein weiteres Schaltmodul mit Speicherfunktionalität umfasst, um das Signal das die Betriebsparameterüberschreitung anzeigt zu speichern. Mit anderen Worten umfasst die erfindungsgemäße Vorrichtung einen Speicher, insbesondere in Form ein weiteren Schaltungsmoduls mit Speicherfunktionalität, um das Signal, welches angibt, dass eine vorgegebene Schwelle des zumindest einen Betriebsparameters unter- oder überschritten worden ist, zu speichern.

Die Erfindung bezieht sich des Weiteren auf ein Verfahren gemäß des Gegenstands des Anspruchs 13.

Die Erfindung wird nachfolgend anhand von Ausführungsbeispielen und unter Bezugnahme auf die beigeschlossenen Zeichnungen näher erläutert. Dabei verweisen gleiche Bezugszeichen auf gleiche oder entsprechende Elemente.

Es zeigen:
**Fig. 1a** einen Integrierten Schaltkreis zusammen mit einer Vorrichtung zur Betriebsparameter-Überwachung nach Stand der Technik in einer Prinzipschaltung. Das Verhalten des IC ist somit in einem bestimmten Bereich außerhalb der zulässigen oder vorgegebenen Betriebsparameter undefiniert, wie in dem Graph auf der rechten Seite skizziert.
**Fig. 1b** zeigt einen Integrierten Schaltkreis zusammen mit einer erfindungsgemäßen Vorrichtung zur Betriebsparameter-Überwachung in einer Prinzipschaltung.
**Fig. 2a** zeigt ein Ausführungsbeispiel einer logischen Grundschaltung zur Betriebsparameter-Überwachung Integrierter Schaltkreise. In Fig. 2a wird dabei die Untergrenze eines Betriebsparameters überwacht.
**Fig. 2b** zeigt das Signalverlaufsdiagramm der in Fig. 2a gezeigten logischen Grundschaltung zur Betriebsparameter-Überwachung innerhalb des zulässigen oder vorgegebenen Betriebsbereichs.
**Fig. 2c** zeigt das Signalverlaufsdiagramm der in Fig. 2a gezeigten logischen Grundschaltung zur Betriebsparameter-Überwachung bei Unterschreiten des zulässigen oder vorgegebenen Betriebsbereichs.
**Fig. 3a** zeigt ein weiteres Ausführungsbeispiel einer logischen Grundschaltung zur Betriebsparameter-Überwachung Integrierter Schaltkreise. In Fig. 3a wird dabei die Unter- und Obergrenze eines Betriebsparameters gleichzeitig überwacht.
**Fig. 3b** zeigt das Signalverlaufsdiagramm der in Fig. 3a gezeigten logischen Grundschaltung zur Betriebsparameter-Überwachung innerhalb des zulässigen oder vorgegebenen Betriebsbereichs.
**Fig. 3c** zeigt das Signalverlaufsdiagramm der in Fig. 3a gezeigten logischen Grundschaltung zur Betriebsparameter-Überwachung bei Überschreiten des zulässigen oder vorgegebenen Betriebsbereichs.
**Fig. 4** zeigt ein weiteres Ausführungsbeispiel einer logischen Grundschaltung zur Betriebsparameter-Überwachung Integrierter Schaltkreise. In Fig. 4 sind dabei zwei Betriebsparameter-Überwachungsschaltungen mit jeweils unterschiedlichen Auslöseschwellen parallel angeordnet.

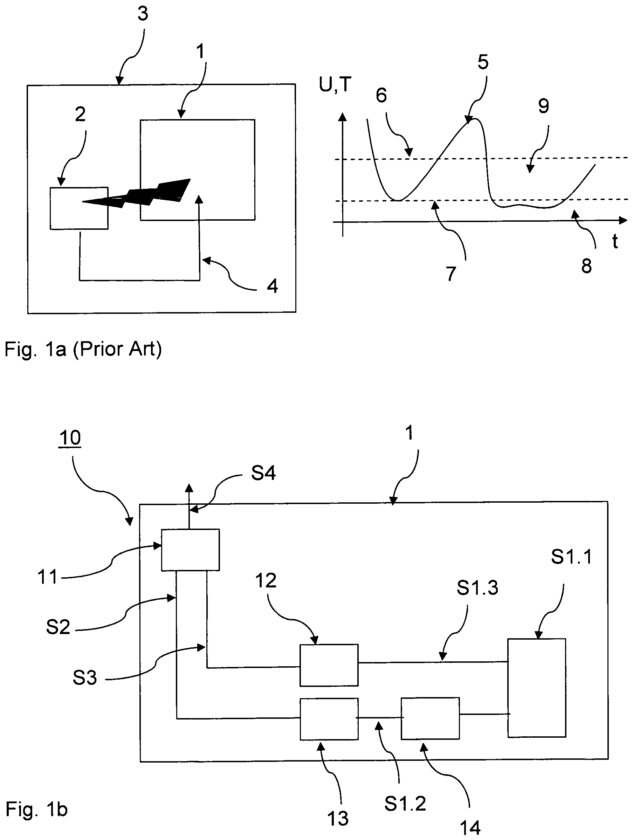

Fig. 1a zeigt einen Integrierten Schaltkreis 1 zusammen mit einer Vorrichtung zur Versorgungsspannungs-Überwachung 2 nach Stand der Technik. Beide Komponenten sind dabei auf einer Leiterplatte 3 aufgebracht. Überschreitet die Spannungsversorgung des IC einen bestimmten Grenzwert, wird ein Resetsignal 4 generiert. Allerdings bleibt ein bestimmter Spannungsbereich in einem Undefinierten Zustand, weil die Versorgungsspannungs-Überwachung 2 nicht bündig an die vorgegebenen oder zulässigen Spannungsgrenzwerte des Integrierten Schaltkreises 1 anschließt. Dies ist in dem Graph auf der rechten Seite von Fig. 1a demonstriert. Hier ist die momentane Versorgungsspannungswert U als Spannungsfunktion 5 über der Zeit t aufgetragen. Der untere Grenzwert der Versorgungsspannung 6 des Integrierten Schaltkreises 1 ist als gestrichelte Linie eingezeichnet. Die Grenzspannung 7 ab welcher die Versorgungsspannungs-Überwachung 2 eingreift ebenfalls. Somit ist nur in einem Bereich 8 garantiert, dass das Überschreiten registriert wird. Der Bereich 9 ist der Bereich, in dem der Integrierte Schaltkreis 1 zwar in einen unzulässigen Betriebsbereich arbeitet, dieser wird aber von der Versorgungsspannungs-Überwachung 2 nicht erkannt. In diesem Bereich kann das funktionsrichtige Arbeiten des Integrierten Schaltkreises 1 nicht garantiert werden.

Wird ein IC außerhalb des zulässigen Bereichs betrieben (beispielsweise mit einer zu kleinen Spannung oder zu hohen Temperatur), schalten die darin enthaltenden Register langsamer. Es kommt zu längeren Signallaufzeiten wodurch die Setup-Zeiten (auch Anstiegszeit, engl. "Setup-time" genannt) für ein folgendes Register nicht eingehalten werden kann und sich dadurch ein falsches Verhalten ergibt.

Die Erfindung nutzt dieses Verhalten gezielt aus um den Zustand des unzulässigen Betriebsbereichs zu erkennen, wie in Fig. 1b beschrieben. Fig. 1b zeigt einen Integrierten Schaltkreis 1, in welchem eine erfindungsgemäße Vorrichtung zur Betriebsparameter-Überwachung 10 implementiert ist, in einer Prinzipschaltung, Dabei werden in einem Vergleichselement 11 Schaltzustände von zwei Eingangssignalen S2, S3 verglichen. Die Eingangssignale S2, S3 werden dabei von zwei betriebsparameterabhängigen Vorrichtungen 12, 13 generiert und je nach momentanen Wert des zumindest einen Betriebsparameters -beispielsweise die Spannungsversorgung- in ihrem Schaltverhalten zeitlich verzögert.

Der Aufbau der erfindungsgemäßen Vorrichtung aus Komponenten des integrierten Schaltkreises bringt den Vorteil, dass die Überwachung so genau wie möglich den gleichen Bedingungen ausgesetzt ist, wie die eigentliche Funktion der integrierten Schaltung. Beispielsweise kann es im IC viel heißer sein als außerhalb, auch die Versorgungsspannung kann im IC Aufgrund von Spannungsabfällen auf dem Versorgungspfad eine andere sein als extern. Jedes IC kann aufgrund von Herstellungsschwankungen unterschiedlich ausfallen und damit etwas andere Grenzen bei den Betriebsparametern aufweisen, Die vorgeschlagene integrierte Betriebsparameterüberwachung auf Basis der Register berücksichtigt diese herstellungsbedingten Grenzen automatisch. Die Herstellungstoleranzen, die Temperatur und die Versorgungsspannung bestimmen im Allgemeinen alle gemeinsam die Grenze einer korrekten Funktion eines integrierten Schaltkreises. Da die erfindungsgemäße Vorrichtung direkt im integrierten Schaltkreis implementiert ist und diese entsprechend wie die übrigen Elemente des Schaltkreises auf Änderungen von Betriebsparametern reagiert, kann damit unabhängig von der Art des oder der Betriebsparameter das Vorliegen von Bedingungen für die korrekte Funktion des integrierten Schaltkreises überwacht werden.

Ist diese Verzögerung z.B. aufgrund eines Absinkens der Spannungsversorgung zu groß, kann es zu dem oben beschriebenen Fehlverhalten des Integrierten Schaltreises 1 kommen. Unabhängig von dieser Verzögerung würde das Vergleichselement 11 aber immer anzeigen das beide Eingangsignale S2, S3 identisch sind, da die Eingangssignale S2, S3 momentan noch in Phase zueinander sind. Wird in die Betriebsparameter-Überwachung 10 jedoch ein Verzögerungselement 14 eingebracht (in Fig. 1b beispielhaft vor der betriebsparameterabhängigen Vorrichtungen 13 eingezeichnet), sind die beiden Eingangssignale S2, S3 nun nicht mehr in Phase. Wird der Verzögerungswert derart gewählt, dass die Setupzeit dieser betriebsparameterabhängigen Vorrichtung 13 bei dem Erreichen der vorgegebenen Grenzwertes der Versorgungsspannung gerade noch eingehalten wird, kann das Überschreiten einfach festgestellt werden. Wird nämlich die Grenze überschritten, wird die vorgegeben Setupzeit des betriebsparameterabhängigen Vorrichtungen 13 nicht mehr eingehalten und am Ausgang S3 wechselt der Schaltzustand. Da die andere betriebsparameterabhängigen Vorrichtungen 12 diese zusätzliche Verzögerung nicht aufweist, ist deren Schaltzustand unverändert. Nun sind die beiden Signale S2 und S3 aber nicht mehr gleich und das Vergleichselement 11 registriert diese Ungleichheit. Da die Verzögerung genau auf die Grenze der Setup-Zeit festgesetzt wurde zeigt das Vergleichselement 11 also genau ein Über- oder Unterschreiten des Grenzwertes an. Dieses Signal kann nun weiter ausgewertet werden, beispielsweise als Resetsignal oder als Signal für Schaltungen, welche die Versorgungsspannung entsprechend erhöhen.

Da die Verzögerung des Verzögerungselements -beispielsweise mittels einer Verzögerungsleitungannähernd beliebig vorgebbar ist, kann sie derart gewählt werden, dass eines der Eingangssignale S2 oder S3 genau dann seinen Zustand wechselt, wenn die Grenze des Betriebsparameters erreicht oder überschritten wurde.

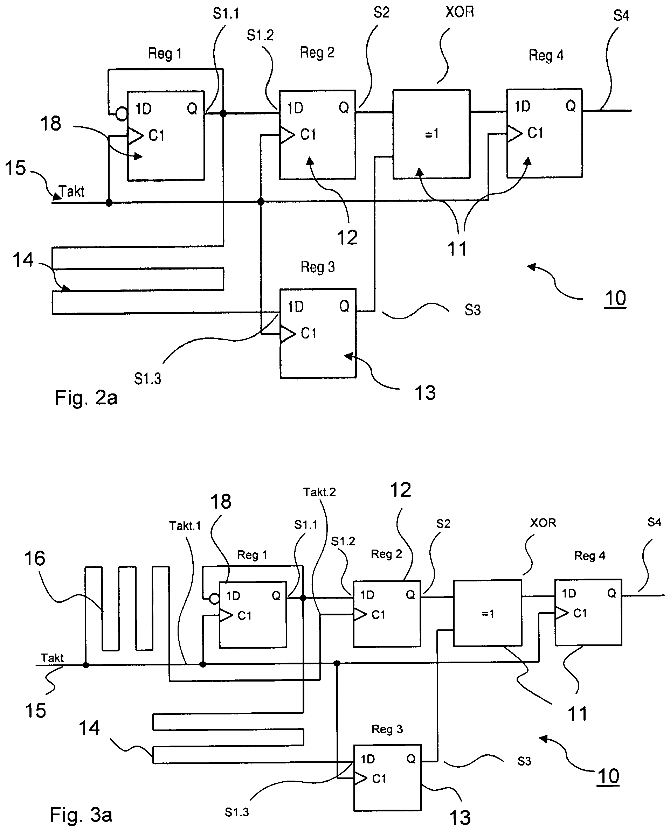

Fig. 2a zeigt ein Ausführungsbeispiel einer solchen logischen Grundschaltung zur Betriebsparameter-Überwachung Integrierter Schaltkreise mittels geeigneter logischer Module. Für eine bessere Zuordnung sind in Fig. 2a die einzelnen Elemente zusätzlich mit den entsprechenden Bezugszeichen aus Fig. 1b versehen.

Demgemäß umfasst bei den folgenden Beispielen das Vergleichselement 11 ein Register Reg 4 und ein XOR-Gatter (in den nachfolgenden Figuren mit =1 bezeichnet), die beiden betriebsparameterabhängigen Vorrichtungen 12, 13 werden durch die Register Reg 2 bzw. Reg 3 realisiert. Weiterhin ist ein Frequenzteiler 18 vorgesehen, der durch ein Register Reg 1 realisiert wird. Als Register dient bei dem dargestellten Beispiel ein D-Flipflop. Um eine Frequenzteilung zu erreichen, ist der Ausgang Q des Registers Reg 1 mit dessen Eingang 1D verbunden. Dadurch ändert sich nach jeder Schaltflanke des Taktsignals der Schaltzustand des Flipflops, so dass nach jeder zweiten Schaltflanke des Taktsignals der Ausgang Q wieder auf seinen Anfangswert zurückkehrt.

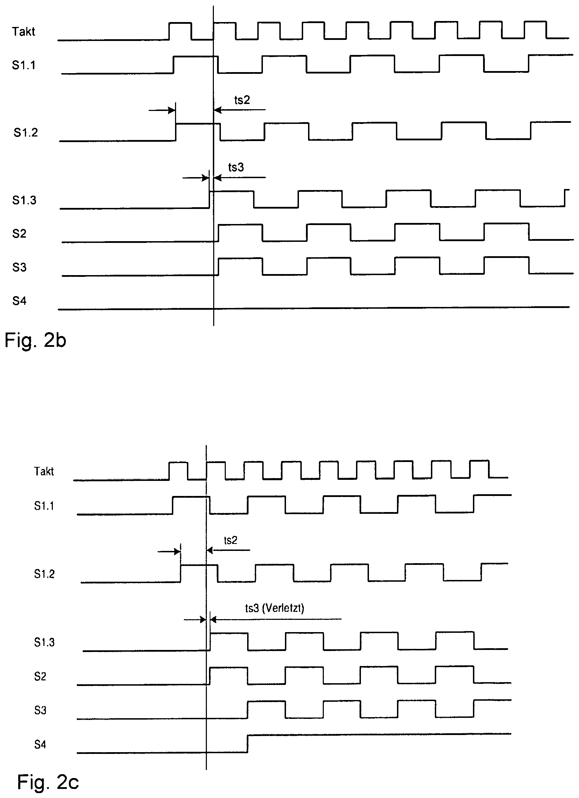

In der Ausführungsform nach Fig. 2a werden die betriebsparameterabhängigen Vorrichtungen durch Register repräsentiert, die wie oben erwähnt, je nach Wert des Betriebsparameters ihre Schaltzeit verändern, Als Register können, wie auch durch die Schaltsymbole ersichtlich, D-Flipflops verwendet werden. In Fig. 2a wird dabei die Untergrenze der Betriebsparameter überwacht. Dazu wird mit einem Register (Reg 1 in Fig. 2a) aus einem Takt 15 ein zweites Taktsignal (S1.1 in Fig. 2a) mit halber Frequenz erzeugt. Das zweite Taktsignal S1.1 wird von zwei Registern Reg 2, Reg 3, beziehungsweise den beiden betriebsparameterabhängigen Vorrichtungen 12, 13 gespeichert. Das Register Reg 3, beziehungsweise die betriebsparameterabhängige Vorrichtung 13 ist über eine lange Verbindung oder eine Verzögerungsleitung 14 mit dem Register Reg 1 verbunden, so das im unteren zulässigen Betriebsbereich seine Setupzeit (ts3 in Fig. 2b) gerade noch eingehalten wird. Demgegenüber ist das Register Reg 2, beziehungsweise die betriebsparameterabhängige Vorrichtung 12 über eine kürzere Verbindung mit Register Reg 1 verbunden, so dass im unteren zulässigen Betriebsbereich seine Setupzeit (ts2 in Fig. 2b) noch mit großer Reserve eingehalten wird. Im gesamten zulässigen Betriebsbereich haben somit die Ausgänge von Register Reg 2 und Register Reg 3 den gleichen Zustand. Ein mit den Ausgängen verbundenes Exklusiv-Oder-Gatter XOR (in Fig. 2a mit "=1" symbolisiert) vergleicht die Ausgangssignale S2, S3 miteinander. Solange die Signale gleich sind, bleibt sein Ausgang inaktiv, Neben den Registern Reg 2 und Reg 3 ist auch das Register Reg 4 des Vergleichselements 11 an den Takt 15 angeschlossen. Das Register Reg 4 fragt unter Ansprechen auf das Taktsignal das Exklusiv-Oder-Gatter XOR ab.

Je nach Wert des Betriebsparameters ergeben sich die Signalverläufe wie in Fig. 2b bzw. 2c gezeigt. In Fig. 2b und Fig. 2c ist dabei das Signalverlaufsdiagramm über der Zeit t aufgetragen. Wird nun der zulässige Betriebsbereich verlassen, indem z.B. die für fehlerfreien Betrieb minimal nötige Spannungsversorgung unterschritten wird, ergeben sich Signalverläufe wie in Fig. 2c gezeigt. Bewegt sich der Betriebsparameter im erlaubten Bereich, ergeben sich die Signalverläufe aus Fig. 2b. Das Signal S1.1 kommt jetzt bei Register Reg 2 etwas später an, als S1.2. Die Setup Zeit ts2 von Register 2 Reg 2 verringert sich, da sie aber große Reserven hat, wird die Setupzeit ts2 nicht unterschritten. Der Ausgang von Register 2 Reg 2 bleibt unverändert.

Auch bei Register Reg 3 kommt das Signal etwas später an (S1.3 in Fig. 2b). Bei Register Reg 3 gibt es aufgrund der Verzögerungsleitung jedoch am Schwellwert des Betriebsparameters keine Reserven bei seiner Setup Zeit ts3. Die Setupzeit von Register Reg 3 wird beim Verlassen des zugelassenen Bereichs des Betriebsparameters unterschritten wodurch sich sein Ausgangssignal S3 um eine Taktperiode verschiebt.

Das Exklusiv-Oder-Gatter (=1 in Fig. 2a) stellt jetzt beim Vergleich zu den durch das am Register Reg 4 durch den Takt 15 vorgegebenen Abfragezeitpunkten des Exklusiv-Oder-Gatters ein Unterschied fest. Das Vergleichsergebnis S4 wird von Register 4 Reg 4 gespeichert und kann als Reset-Signal verwendet werden.

Mit anderen Worten werden die Register als Messregister verwendet, d.h. sie dienen als Messgröße für die restlichen Register des Integrierten Schaltkreises mit denen festgestellt wird, ab wann die Betriebsparameter allgemein, bzw. die Kombination der Versorgungsspannung, der Temperatur und der Herstellungsbedingten Eigenschaften des individuellen Integrierten Schaltkreises ein zeitrichtiges Schalten nicht mehr zulassen.

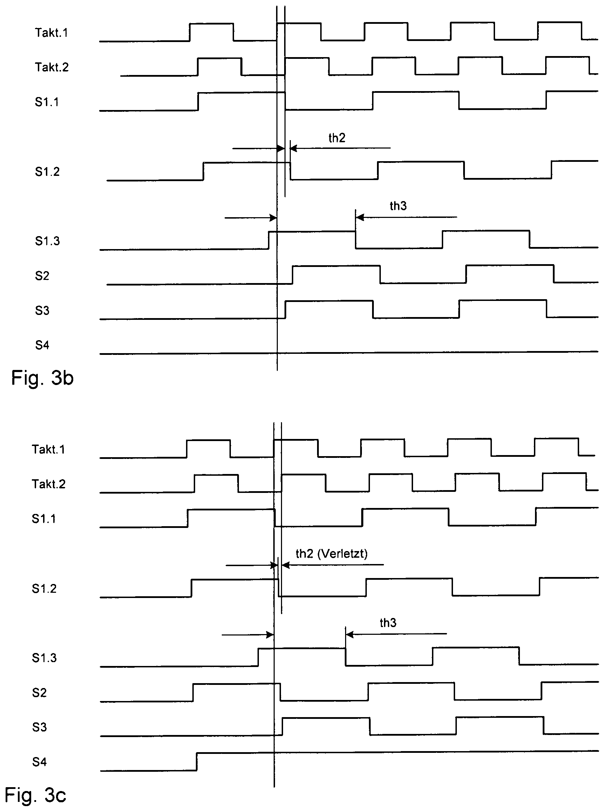

Nach diesem Prinzip kann auch die obere Grenze des Betriebsbereichs überwacht werden (zu große Spannungsversorgung, zu tiefe Temperaturen). In diesem Fall schalten die Register schneller und die Signallaufzeiten verkürzen sich. Damit dieser Zustand erkannt werden kann, wird das Register 12 (Reg 2) so verbunden, dass im oberen zulässigen Betriebsbereich seine Holdzeit (auch Haltezeit; engl. Hold-time genannt) gerade noch eingehalten werden kann. Bei Überschreiten des zulässigen Betriebsbereichs wird die Holdzeit verletzt. Fig. 3b zeigt die Signale im Fall eines Betriebs knapp unter dem zulässigen oberen Betriebsbereich. Die Holdzeit th2 wird gerade noch eingehalten, während th3 noch reichlich Reserve hat.

Fig. 3c zeigt die Signale im Fall eines Betriebs oberhalb des zulässigen oberen Betriebsbereichs. Die Holdzeit th2 wird verletzt und das Ausgangssignal von Register 2 verschiebt sich um eine Taktperiode. So wird auch in diesem Fall vom Exklusiv-Oder-Gatter (=1 in Fig. 3a) ein Unterschied erkannt und damit ein Reset-Signal erzeugt.
Damit die Holdzeit in Register Reg 2, im oberen Betriebsbereich gerade noch eingehalten wird, ist dessen Verbindung mit dem Taktsignal mittels eines weiteren Verzögerungselements 16 deutlich länger ausgelegt als bei den anderen Registern (siehe Fig. 3a im Vergleich zu Fig. 2a). Die Schaltung aus Fig. 3a mit den Verzögerungselementen 14 und 16, welche die Ausgangssignale beider betriebsparameterabhängigen Vorrichtungen 12, 13 unterschiedlich verzögern, kann dabei den oberen und unteren vorgegebenen Grenzwert des Betriebsparameters gleichzeitig überwachen und kann somit die Schaltung nach Fig. 2a ersetzen. Das Prinzip der Vorrichtung gemäß Fig. 3a beruht zusammenfassend also darauf, dass mit dem Verzögerungselement 14 und dem weiteren Verzögerungselement 16 die Eingangssignale des Vergleichselements 11 relativ zueinander und zum Takt 15 so verzögert werden, dass bei Überschreiten eines ersten oberen Schwellwerts des oder der Betriebsparameter eines der Eingangssignale (S2, S3) zu dem, durch das Taktsignal (S1.1) dem Vergleichselement (11) vorgegebenen Zeitpunkten, seinen Schaltzustand aufgrund der vorgegebenen zeitlichen Verzögerung ändert, und bei Unterschreiten eines zweiten, unteren Schwellwerts des oder der Betriebsparameter das andere der Eingangssignale (S2, S3) zu dem, durch das Taktsignal (S1.1) dem Vergleichselement 11 vorgegebenen Zeitpunkten, seinen Schaltzustand aufgrund der vorgegebenen zeitlichen Verzögerung ändert, Dabei ist jeweils eines Verzögerungselement 14, 16 den Takteingängen C1 der betriebsparameterabhängigen Vorrichtungen 12, 13 vorgeschaltet.
In einem Integrierten Schaltkreis lassen sich beide Schaltungen leicht realisieren. In einem FPGA ist die Schaltung nach Fig. 2a einfacher zu programmieren als nach Fig. 3a.

Sinkt die Versorgungsspannung auf einen so kleinen Wert, dass selbst die Überwachungs-Schaltung nicht mehr funktioniert, kann dies auch sehr einfach von einer ungenauen Integrierten Spannungsüberwachung erkannt werden. Die Kombination einer sehr einfachen herkömmlichen Integrierten Spannungsüberwachung mit der hier beschriebenen Überwachung ergibt eine sehr kostengünstige aber dennoch sehr genaue Überwachung aller Betriebsparameter.

Eine eventuell gewünschte Sicherheitsreserve bei der Betriebsparameterüberwachung kann beeinflusst werden, indem die Überwachungsschaltung so ausgelegt wird, dass sie entsprechend früh auslöst.

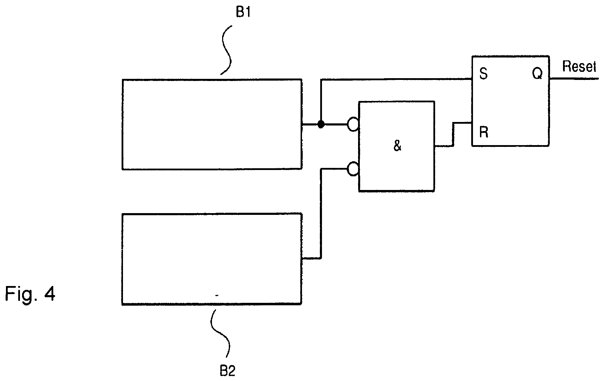

Es ist auch möglich eine Hysterese für die Reset-Generierung zu realisieren, indem die Betriebsparameterüberwachung zweimal mit unterschiedlichen Auslöseschwellen aufgebaut wird (siehe Fig. 4). Die Schaltung mit der weniger empfindlicheren Auslöseschwelle (B1 in Fig.4) kann den Reset aktivieren und wenn beide Schaltungen (B1 und B2 in Fig.4) einen zulässigen Betriebsbereich detektieren kann der Reset wider zurückgenommen werden.

Ebenso ist es möglich, den Reset nicht direkt von der Betriebsparameterüberwachung zu erzeugen sondern einen Digitalen Filter zwischenzuschalten.

Es ist dem Fachmann ersichtlich, dass die Erfindung nicht auf die vorstehend beschriebenen Ausführungsbeispiele beschränkt ist, sondern in vielfältiger Weise variiert werden kann. Zum Beispiel können auch mehrere Vorrichtungen zur Betriebsparameter-Überwachung nebeneinander angeordnet sein bzw. parallel arbeiten, um beispielsweise die Betriebsparameter an verschieden Stellen innerhalb des Integrierten Schaltkreises zu überwachen.

Insbesondere kann die Erfindung in allen digitalen und/oder logischen Schaltungen eingesetzt und verwendet werden. Weiterhin kann die Schaltung einfach abgewandelt werden, um mit negativen Holdzeiten betrieben zu werden.
Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind.

## Patentansprüche

1. Überwachungsvorrichtung (10) zur Betriebsparameter-Überwachung eines integrierten Schaltkreises (1),
- welche dazu ausgebildet ist, durch einen Vergleich von Schaltzuständen von Eingangssignalen (S2, S3) an zumindest zwei Eingängen eines Vergleichselements (11), an zumindest einem Ausgang des Vergleichselements (11) ein Signal (S4) zu generieren, das angibt, dass eine vorgegebene Schwelle des zumindest einen Betriebsparameters unter- oder überschritten worden ist, wobei
- die Überwachungsvorrichtung (10) zumindest zwei betriebsparameterabhängige Vorrichtungen (12, 13) umfasst, welche dazu ausgebildet sind, die Eingangssignale (S2, S3) zu generieren, welche, je nach momentanem Wert des zumindest einen Betriebsparameters, in ihrem Schaltverhalten zeitlich verzögert sind,
- ein Taktsignal (S1.1) an die beiden betriebsparameterabhängigen Vorrichtungen (12, 13) angeschlossen ist, wobei sich das Taktsignal (S1.1) auf zwei Signalwege aufteilt, über die Signale übertragen werden, welche jeweils als Eingangssignale für die betriebsparameterabhängigen Vorrichtungen (12, 13) dienen,
- in einem der Signalwege ein Verzögerungselement (14) geschaltet ist, welches dazu ausgebildet ist, zwischen den Eingangssignalen (S2, S3) des Vergleichselements (11) eine vorgegebene zeitliche Verzögerung zu erzeugen, und
- die Verzögerung des Verzögerungselements (14) einen Wert aufweist derart, dass bei Überschreiten der vorgegebenen Schwelle des Betriebsparameters, eines der Eingangssignale (S2, S3) zu einem durch das Taktsignal (S1.1) dem Vergleichselement (11) vorgegebenen Zeitpunkt seinen Schaltzustand aufgrund der Verzögerung ändert, so dass das Vergleichselement (11) eine Ungleichheit anzeigt und damit ein Überschreiten der Schwelle des zumindest einen Betriebsparameters signalisiert wird.

2. Überwachungsvorrichtung (10) nach Anspruch 1, **dadurch gekennzeichnet, dass** eine durch das Verzögerungselement (14) bedingte zeitliche Verzögerung des Eingangssignals (S1.2, S1.3) gerade noch eine vorgegebene Anstiegs- oder Haltezeit der einen betriebsparameterabhängigen Vorrichtung (12, 13) einhält, so dass bei Überschreiten der vorgegebenen Schwelle des Betriebsparameters eines der Eingangssignale (S2, S3) seinen Schaltzustand ändert und somit das Vergleichselement (11) eine Ungleichheit anzeigt und damit ein Überschreiten der Schwelle des zumindest einen Betriebsparameters signalisiert wird.

3. Überwachungsvorrichtung (10) nach einem der vorstehenden Ansprüche, **dadurch gekennzeichnet, dass** die Generierung der beiden Eingangssignale durch einen Takt (15) gesteuert wird, der an den beiden betriebsparameterabhängigen Vorrichtungen (12, 13) und an das Vergleichselement (11) angeschlossen ist.

4. Überwachungsvorrichtung (10) nach einem der vorstehenden Ansprüche **dadurch gekennzeichnet, dass** ein weiteres Verzögerungselement (16) vorgesehen ist, so dass mit dem Verzögerungselement (14) und dem weiteren Verzögerungselement (16) die Eingangssignale des Vergleichselements (11) relativ zueinander und zum Takt (15) so verzögert werden, dass bei Überschreiten eines ersten oberen Schwellwerts eines Betriebsparameters eines der Eingangssignale (S2, S3) zu dem, durch das Taktsignal (S1.1) dem Vergleichselement (11) vorgegebenen Zeitpunkten seinen Schaltzustand aufgrund der vorgegebenen zeitlichen Verzögerung ändert, und bei Unterschreiten eines zweiten, unteren Schwellwerts eines Betriebsparameters das andere der Eingangssignale (S2, S3) zu dem, durch das Taktsignal (S1.1) dem Vergleichselement 11 vorgegebenen Zeitpunkten, seinen Schaltzustand aufgrund der vorgegebenen zeitlichen Verzögerung ändert.

5. Überwachungsvorrichtung (10) nach einem der vorstehenden Ansprüche **dadurch gekennzeichnet, dass** die Überwachungsvorrichtung (10) in einer Logischen Schaltung, einem Mikroprozessor, einem Digitalen Signalprozessor, einem CPLD, einem FPGA oder in einem ASIC implementiert ist.

6. Überwachungsvorrichtung (10) nach einem der vorstehenden Ansprüche **dadurch gekennzeichnet, dass** die betriebsparameterabhängigen Vorrichtungen (12) und (13) durch D-FlipFlops realisiert werden.

7. Überwachungsvorrichtung (10) nach einem der vorstehenden Ansprüche **dadurch gekennzeichnet, dass** das Vergleichselement (11) eine Exklusiv-Oder-Verknüpfung, bzw. Exklusiv-Oder-Funktionalität aufweist.

8. Überwachungsvorrichtung (10) nach einem der vorstehenden Ansprüche, **gekennzeichnet durch** einen Frequenzteiler für das Taktsignal (S1.1).

9. Überwachungsvorrichtung (10) nach einem der vorstehenden Ansprüche, **gekennzeichnet durch** einen Spannungsmonitor.

10. Überwachungsvorrichtung (10) nach einem der vorstehenden Ansprüche, **gekennzeichnet durch** einen Speicher, insbesondere in Form ein weiteren Schaltungsmoduls mit Speicherfunktionalität, um das Signal (S4), das angibt, dass eine vorgegebene Schwelle des zumindest einen Betriebsparameters unter- oder überschritten worden ist, zu speichern.

11. System zur Betriebsparameter-Überwachung, **gekennzeichnet durch** zumindest zwei Betriebsparameter-Überwachungsvorrichtungen (10) nach einem der vorstehenden Ansprüche, die jeweils unterschiedliche Auslöseschwellen aufweisen und in einer Parallelanordnung angeordnet sind.

12. Integrierter Schaltkreis mit einer Überwachungsvorrichtung (10) oder einem System zur Betriebsparameter-Überwachung nach einem der vorstehenden Ansprüche.

13. Verfahren zur Betriebsparameter-Überwachung eines integrierten Schaltkreises (1), wobei
- zwei Eingangssignale (S2, S3), die je nach momentanem Wert von zumindest einem Betriebsparameter in ihrem Schaltverhalten zeitlich verzögert sind, von zwei betriebsparameterabhängigen Vorrichtungen (12, 13) generiert und an die Eingänge eines Vergleichselements (11) zugeführt werden,
- das Vergleichselement (11) an seinem Ausgang ein Signal (S4) generiert mittels eines Vergleichs von Schaltzuständen der Eingangssignale (S2, S3), wobei das Signal (S4) angibt, dass eine vorgegebene Schwelle des zumindest einen Betriebsparameters unter- oder überschritten wurde, indem
- ein Taktsignal (S1.1) den betriebsparameterabhängigen Vorrichtungen (12, 13) zugeführt und zwischen den Eingangssignalen (S2, S3) des Vergleichselements (11) eine zeitliche Verzögerung mittels mindestens eines Verzögerungselements (14) erzeugt wird, wobei
- die Verzögerung des Verzögerungselements (14) derart eingestellt wird, dass bei Überschreiten einer vorgegebenen Schwelle des Betriebsparameters, eines der Eingangssignale (S2, S3) zu einem durch das Taktsignal (S1.1) dem Vergleichselement (11) vorgegebenen Zeitpunkt seinen Schaltzustand aufgrund der Verzögerung ändert, so dass das Vergleichselement (11) eine Ungleichheit anzeigt und damit ein Überschreiten der Schwelle des zumindest einen Betriebsparameters signalisiert.

## Claims

1. A monitoring device (10) for monitoring operating parameters of an integrated circuit (1),
- adapted for generating, by comparison of switching states of input signals (S2, S3) on at least two inputs of a comparison element (11), a signal (S4) on at least one output of said comparison element (11), which signal indicates that a predetermined threshold of the at least one operating parameter has been undershot or exceeded; wherein
- the monitoring device (10) comprises at least two operating parameter-dependent devices (12, 13) which are adapted for generating said input signals (S2, S3) which are time-delayed in their switching behaviour depending on the instantaneous value of the at least one operating parameter;
- wherein a clock signal (S1.1) is connected to the two operating parameter-dependent devices (12, 13), said clock signal (S1.1) being divided into two signal paths over which signals are transmitted which serve as a respective input signal for the operating parameter-dependent devices (12, 13);
- wherein a delay element (14) is connected in one of the signal paths, which is adapted to generate a predetermined time delay between the input signals (S2, S3) of the comparison element (11); and
- wherein the delay of the delay element (14) has a value such that when the predetermined threshold of the operating parameter is exceeded, one of the input signals (S2, S3) changes its switching state due to the time delay at a time which is predetermined for the comparison element (11) by the clock signal (S1.1), so that the comparison element (11) indicates a disparity and thus an exceeding of the threshold of the at least one operating parameter is signalled.

2. The monitoring device (10) according to claim 1, **characterized in that** a time delay of the input signal (S1.2, S1.3) as caused by the delay element (14) just meets a predetermined rise or hold time of the one operating parameter-dependent device (12, 13), so that when the predetermined threshold of the operating parameter is exceeded, one of the input signals (S2, S3) changes its switching state and so the comparison element (11) indicates a disparity and thus an exceeding of the threshold of the at least one operating parameter is signalled.

3. The monitoring device (10) according to any one of the preceding claims, **characterized in that** the generation of the two input signals is controlled by a clock (15) which is connected to the two operating parameter-dependent devices (12, 13) and to the comparison element (11).

4. The monitoring device (10) according to any one of the preceding claims, **characterized in that** a further delay element (16) is provided, so that with the delay element (14) and the further delay element (16) the input signals of the comparison element (11) are delayed relative to each other and to the clock (15) such that when a first, upper threshold value of an operating parameter is exceeded, one of the input signals (S2, S3) changes its switching state due to the predetermined time delay at the time which is predetermined for the comparison element (11) by the clock signal (S1.1), and when an operating parameter falls below a second, lower threshold value the other one of the input signals (S2, S3) changes its switching state due to the predetermined time delay at the time which is predetermined for the comparison element (11) by the clock signal (S1.1).

5. The monitoring device (10) according to any one of the preceding claims, **characterized in that** the monitoring device (10) is implemented in a logic circuit, a microprocessor, a digital signal processor, a CPLD, an FPGA, or in an ASIC.

6. The monitoring device (10) according to any one of the preceding claims, **characterized in that** the operating parameter-dependent devices (12) and (13) are implemented by D-type flip-flops.

7. The monitoring device (10) according to any one of the preceding claims, **characterized in that** the comparison element (11) comprises an exclusive-OR operation, or exclusive-OR functionality.

8. The monitoring device (10) according to any one of the preceding claims, **characterized by** a frequency divider for the clock signal (S1.1).

9. The monitoring device (10) according to any one of the preceding claims, **characterized by** a voltage monitor.

10. The monitoring device (10) according to any one of the preceding claims, **characterized by** a memory, in particular in the form of another circuit module with memory functionality, for storing the signal (S4) which indicates that a predetermined threshold of the at least one operating parameter has been undershot or exceeded.

11. A system for monitoring operating parameters, **characterized by** at least two operating parameter monitoring devices (10) each of which has a different triggering threshold and which are arranged in a parallel arrangement.

12. An integrated circuit comprising a monitoring device (10) or a system for monitoring operating parameters according to any one of the preceding claims.

13. A method for monitoring operating parameters of an integrated circuit (1), wherein
- two input signals (S2, S3) which are time-delayed in their switching behaviour depending on the instantaneous value of at least one operating parameter are generated by two operating parameter-dependent devices (12, 13) and are supplied to the inputs of a comparison element (11);
- the comparison element (11) generates a signal (S4) at its output by comparing switching states of the input signals (S2, S3), wherein the signal (S4) indicates that a predetermined threshold of the at least one operating parameter has been undershot or exceeded; by
- supplying a clock signal (S1.1) to the operating parameter-dependent devices (12, 13) and generating a time delay between the input signals (S2, S3) of the comparison element (11) by at least one delay element (14); wherein
- the delay of the delay element (14) is set such that when a predetermined threshold of the operating parameter is exceeded, one of the input signals (S2, S3) changes its switching state due to the delay at a time predetermined for the comparison element (11) by the clock signal (S1.1), so that the comparison element (11) indicates a disparity and thus an exceeding of the threshold of the at least one operating parameter is signalled.

## Revendications

1. Dispositif de surveillance (10) pour la surveillance de paramètres de fonctionnement d'un circuit intégré (1),
- lequel est conçu pour générer un signal (S4) à la suite d'une comparaison d'états de commutation de signaux d'entrée (S2, S3) à au moins deux entrées d'un élément de comparaison (11), à au moins une sortie de l'élément de comparaison (11), lequel signal indique qu'un seuil prédéfini de l'au moins un paramètre de fonctionnement n'a pas été atteint ou a été dépassé,
où
- le dispositif de surveillance (10) comporte au moins deux dispositifs (12, 13) dépendants des paramètres de fonctionnement, lesquels sont conçus pour générer les signaux d'entrée (S2, S3) dont le comportement de commutation est décalé dans le temps en fonction de la valeur momentanée de l'au moins un paramètre de fonctionnement,
- un signal d'horloge (S1.1) est connecté aux deux dispositifs (12, 13) dépendants des paramètres de fonctionnement, le signal d'horloge (S1.1) se divisant en deux voies de signal par l'intermédiaire desquelles les signaux sont transmis, lesquels servent respectivement de signaux d'entrée pour les dispositifs (12, 13) dépendants des paramètres de fonctionnement,
- dans une des voies de signal, un élément de décalage (14) est commuté, lequel est conçu pour produire un décalage dans le temps prédéfini entre les signaux d'entrée (S2, S3) de l'élément de comparaison (11), et
- le décalage de l'élément de décalage (14) présente une valeur telle que, lorsque le seuil prédéfini du paramètre de fonctionnement est dépassé, l'un des signaux d'entrée (S2, S3) modifie son état de commutation sur la base du décalage à un moment prédéfini par le signal d'horloge (S1.1) pour l'élément de comparaison (11), de sorte que l'élément de comparaison (11) montre une inégalité et signale ainsi un dépassement du seuil de l'au moins un paramètre de fonctionnement.

2. Dispositif de surveillance (10) selon la revendication 1, **caractérisé en ce qu'**un décalage dans le temps du signal d'entrée (S1.2, S1.3) provoqué par l'élément de décalage (14) observe tout juste un temps de montée ou de maintien prédéfini d'un des dispositifs (12, 13) dépendants des paramètres de fonctionnement, de sorte que lorsque le seuil prédéfini du paramètre de fonctionnement est dépassé, l'un des signaux d'entrée (S2, S3) modifie son état de commutation et donc l'élément de comparaison (11) montre une inégalité et un dépassement du seuil de l'au moins un paramètre de fonctionnement est ainsi signalé.

3. Dispositif de surveillance (10) selon l'une quelconque des revendications précédentes, **caractérisé en ce que** la génération des deux signaux d'entrée est commandée par une horloge (15), qui est connectée aux deux dispositifs (12, 13) dépendants des paramètres de fonctionnement et à l'élément de comparaison (11).

4. Dispositif de surveillance (10) selon l'une quelconque des revendications précédentes, **caractérisé en ce qu'**un autre élément de décalage (16) est prévu, de sorte que les signaux d'entrée de l'élément de comparaison (11) sont décalés les uns par rapport aux autres et par rapport à l'horloge (15) au moyen de l'élément de décalage (14) et de l'autre élément de décalage (16), de sorte que lorsqu'une première valeur seuil supérieure d'un paramètre de fonctionnement est dépassée, un des signaux d'entrée (S2, S3) modifie son état de commutation sur la base du décalage dans le temps prédéfini au moment prédéfini par le signal d'horloge (S1.1) pour l'élément de comparaison (11), et lorsqu'une deuxième valeur seuil inférieure d'un paramètre de fonctionnement n'est pas atteinte, l'autre signal d'entrée des signaux d'entrée (S2, S3) modifie son état de commutation sur la base du décalage dans le temps prédéfini au moment prédéfini par le signal d'horloge (S1.1) pour l'élément de comparaison (11).

5. Dispositif de surveillance (10) selon l'une quelconque des revendications précédentes, le dispositif de surveillance (10) étant **caractérisé en ce qu'**il est implémenté dans un circuit logique, un microprocesseur, un processeur de signal numérique, un CPLD, un FGPA ou dans un ASIC.

6. Dispositif de surveillance (10) selon l'une quelconque des revendications précédentes, **caractérisé en ce que** les dispositifs (12) et (13) dépendants des paramètres de fonctionnement sont réalisés par des bascules D.

7. Dispositif de surveillance (10) selon l'une quelconque des revendications précédentes, **caractérisé en ce que** l'élément de comparaison (11) présente une opération Ou exclusif, ou une fonction Ou exclusif.

8. Dispositif de surveillance (10) selon l'une quelconque des revendications précédentes, **caractérisé par** un diviseur de fréquence pour le signal d'horloge (S1.1).

9. Dispositif de surveillance (10) selon l'une quelconque des revendications précédentes, **caractérisé par** un moniteur de tension.

10. Dispositif de surveillance (10) selon l'une quelconque des revendications précédentes, **caractérisé par** une mémoire, en particulier se présentant sous forme d'un autre module de commutation pourvu d'une fonction de mémoire, afin de mettre en mémoire le signal (S4) qui indique qu'un seuil prédéfini de l'au moins un paramètre de fonctionnement n'a pas été atteint ou a été dépassé.

11. Système de surveillance de paramètre de fonctionnement, **caractérisé par** au moins deux dispositifs de surveillance (10) de paramètre de fonctionnement selon l'une quelconque des revendications précédentes, qui présentent chacun des seuils de déclenchement différents et qui sont agencés dans un montage parallèle.

12. Circuit intégré comprenant un dispositif de surveillance (10) ou un système de surveillance de paramètre de fonctionnement selon l'une quelconque des revendications précédentes.

13. Procédé de surveillance de paramètre de fonctionnement d'un circuit intégré (1), dans lequel :
- deux signaux d'entrée (S2, S3), dont le comportement de commutation est décalé dans le temps en fonction de la valeur momentanée d'au moins un paramètre de fonctionnement, sont générés par deux dispositifs (12, 13) dépendants des paramètres de fonctionnement et sont amenés aux entrées d'un élément de comparaison (11),
- l'élément de comparaison (11) génère à sa sortie un signal (S4) au moyen d'une comparaison des états de commutation des signaux d'entrée (S2, S3), dans lequel le signal indique qu'un seuil prédéfini de l'au moins un paramètre de fonctionnement n'a pas été atteint ou a été dépassé, par le fait
- qu'un signal d'horloge (S1.1) est amené aux deux dispositifs (12, 13) dépendants des paramètres de fonctionnement et qu'un décalage dans le temps est généré au moyen d'au moins un élément de décalage (14) entre les signaux d'entrée (S2, S3) de l'élément de comparaison (11), où
- le décalage de l'élément de décalage (14) est réglé de telle sorte que, lorsqu'un seuil prédéfini du paramètre de fonctionnement est dépassé, l'un des signaux d'entrée (S2, S3) modifie son état de commutation sur la base du décalage à un moment prédéfini par le signal d'horloge (S1.1) pour l'élément de comparaison (11), de sorte que l'élément de comparaison (11) montre une inégalité et signale ainsi un dépassement du seuil de l'au moins un paramètre de fonctionnement.
